# EUROPEAN PATENT APPLICATION

(11) **EP 1 478 019 A1**
(43) Date of publication of application: **17.11.2004**
(21) Application number: 03010728.8
(22) Date of filing: 14.05.2003
(51) Int. Cl.: H01L 23/467

(54) **Streamline heat sink and method for manufacturing the heat sink**

(71) Applicant: Thomson Licensing S.A., 92648 Boulogne Cedex (FR)
(72) Inventor: Tsang, Wing Hon, North Point, Hong Kong (CN); Chiu, Ronald, Hong Kong (CN)
(74) Representative: Rossmanith, Manfred, Dr.

(57) **Abstract**

A heat sink is proposed comprising a base defining a base plane extending in a longitudinal and a transversal direction. The base is provided with fins extending along the longitudinal direction and a way from the base plane. The base and the fins are arranged to allow an airflow along the longitudinal direction. A front end of the fins facing the airflow exhibits a surface shape enabling a substantially laminar airflow. The substantially laminar airflow is efficient to provide a good heat transfer between the heat sink and the air. Furthermore, a substantially laminar airflow is relatively silent compared to a turbulent airflow.

In addition, a method for manufacturing the inventive heat sink is suggested.

## Description

Heat sinks are widely used in electric or electronic devices. There is a large variety of different types or shapes of heat sinks. But all of them are intended for the purpose of thermal management of the device to ensure that the temperature of all components in a system is maintained within its maximum rating. A commonly used approach to transport the heat away from the component is to bring the heat sink being in thermal contact to the package of a component. Conventionally, the heat sink is made of an aluminium alloy. Aluminium and its alloys are interesting materials from an economical point of view because of their relatively low cost compared to copper and the easiness it can be dressed into various shapes by conventional manufacturing methods like moulding and sawing.

Steadily increasing power consumption and in particular power dissipation inside devices presents a problem with regard to the management of the increasing amount of heat in the sense that excessive temperatures have to be avoided. Several methods for transferring heat from the interior of a device to the exterior are known. Among them free air convection is the least efficient one. If there is a need to transfer a larger amount of heat the application of convection implies the use of a larger heat sink at increased costs. In addition, it may still occur that a system inside a housing reaches higher temperatures than it is desirable. This problem is frequently addressed by using fans generating a forced airflow streaming along the heat sink. This approach allows using smaller and therefore more cost-efficient heats sinks for achieving a given cooling power. This type of heat sink arranged with a fan generating a forced air stream is widely applied to cope with heat dissipation of microprocessors. However, the fan generates acoustic noise. Among other conditions the noise level also depends on the power of the fan and easily exceeds acceptable limits. It is a complicated task for the designer of a device to find the right compromise between the size and shape of the heat sink, the power of the fan, the maximum temperature inside a housing and the acceptable noise level.

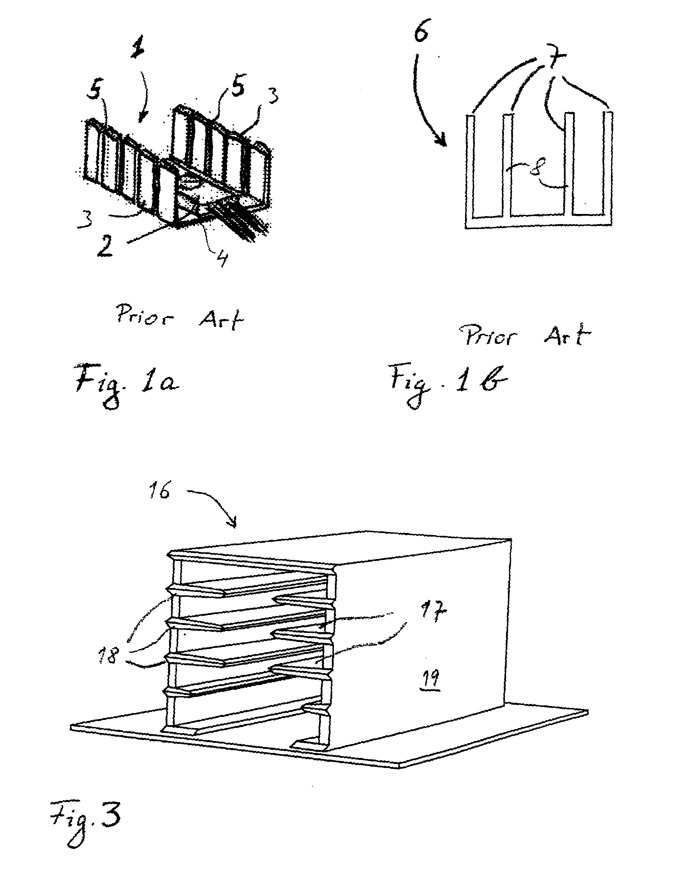

The structure of these heat sinks is formed by the process of extruding the molten aluminium alloy from the moulding and of subsequent cutting the elongated extruded rod into smaller parts after cooling. The cutting process produces flat front ends of the fins as it is shown in Fig. 1. This structure is widely spread and provides acceptable cooling efficiency for many applications.

It is a first object of the invention to propose a heat sink having a higher cooling efficiency and/or lower noise level in connection with forced airflows.

This object is solved by a heat sink comprising a base defining a base plane extending in a longitudinal and a transversal direction. The base is provided with fins extending along the longitudinal direction and a way from the base plane. The base and the fins are arranged to allow an airflow along the longitudinal direction. A front end of the fins facing the airflow exhibits a surface shape enabling a substantially laminar airflow. The substantially laminar airflow is efficient to provide a good heat transfer between the heat sink and the air. Furthermore, a substantially laminar airflow is relatively silent compared to a turbulent airflow.

In a particular embodiment of the invention the front ends of the fins facing the airflow have a triangular, circular or streamline cross-section.

The base may form part of the tunnel guiding the airflow in a tunnel-type heat sink. In this case it is advantageous if the fins extend to the interior of the tunnel to make good thermal contact with the airflow. In another embodiment of the invention several sets of fins are attached to different sidewalls of the tunnel.

The sets of fins on different sidewalls may be of different size and/or shape to address different cooling requirements of components attached to the respective sidewalls.

It is a second object of the invention to suggest a method for manufacturing the invention heat sink.

The second object is solved by a method according to claim 6. At first a rod-like profiled body is extended from an extender. Then the body is separated into several parts in such a way that the cross-section of at least one front end of each part has a triangular shape.

According to an embodiment of the inventive method, the step of separating the profiled body is performed by punching the profiled body.

According to another embodiment of the invention, the step of separating the profiled body is performed by cutting the profiled body and subsequent grinding of at least one front end of each part of the profiled body.

The drawing displays exemplary embodiments of the present invention. It shows:
Fig. 1a a conventional heat sink for a single component;
Fig. 1b a cross section of another conventional elongated heat sink;
Fig. 2a a conventional tunnel-type heat sink;
Fig. 2b the heat sink of Fig. 2a with an attached fan;
Fig. 3 a tunnel-type heat sink according to the invention;
Fig. 4 illustrates a flow diagram of a first method for manufacturing the inventive heat sink; and
Fig. 5 displays a flow diagram of a second method for manufacturing the inventive heat sink.

In Fig. 1a shows a conventional heat sink 1 having an electronic component 2 mounted thereon. The electronic component generates heat and has to be cooled. Therefore, is in thermal contact with the heat sink. The heat sink 1 transports the heat away from the component 2 and into the surrounding environment by passive convection of air. To support this process the heat sink is provided with a plurality of tongues 3 connected to a base 4 of the heat sink. The tongues 3 are separated by intermediate spaces 5 to increase the surface of the heat sink exposed to the cooling airflow.

A similar heat sink 6 is shown in Fig. 1b. The heat sink 6 is a piece of an extruded aluminium profile and exhibits longitudinal ledges 7. Being cut from a long extruded profile the heat sink 6 presents flat front ends 8. The heat sink 6 is suitable both for cooling by free convection of air as well as for cooling by a forced airflow generated by fan and flowing in longitudinal direction of the ledges 7.

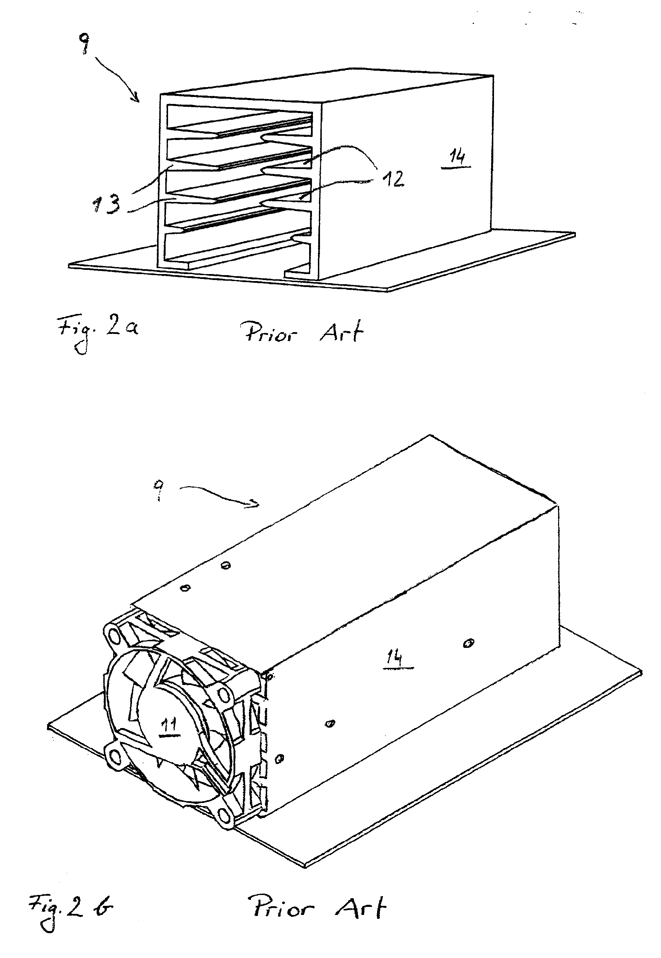

Yet another embodiment of a conventional heat sink 9 is shown in Fig. 2. The heat sink 9 is a tunnel-type heat sink. Electronic components to be cooled are mounted on the exterior of the tunnel and in the interior of the tunnel an airflow forced by a fan 11 is cooling the heat sink. Fig. 2b shows the fan 11 mounted in operating position on the heat sink 9.

With reference back to Fig. 2a the heat sink 9 is provided with a number of fins 12 directed to the interior of the heat sink increasing the surface exposed to the cooling airflow and consequently the cooling efficiency of the heat sink 9. For technical reasons imposed by the manufacturing process through extrusion the cross section of the fins 12 is widening towards the base of the fins attached to the tunnel walls forming a base 14. Due to the cutting process the front ends 13 of the fins present a flat surface facing the airflow blown by the fan 11. The flat front end 13 of the fin 12 is a substantial obstacle for the airflow causing turbulences and acoustic noise, especially in the area of the widened base of fins.

For free air convection the flat front ends 13 of the fins 12 do not significantly degrade the cooling efficiency of the heat sink 9. However, if a forced airflow is blown by the fan 11, the collision of air molecules at high speed with the flat front 13 end is no longer negligible and causes turbulences in the airflow. Compared to a laminar airflow a turbulent airflow is reduced in terms of volume and therefore a turbulent airflow is less efficient for cooling the heat sink. The detrimental effect is most serious in the area of the base of the fin where at the same time the highest airspeed and the biggest cross sectional area of the fins occlude the airflow. Besides a reduced cooling performance of the turbulent airflow the turbulences also cause an elevated acoustic noise level.

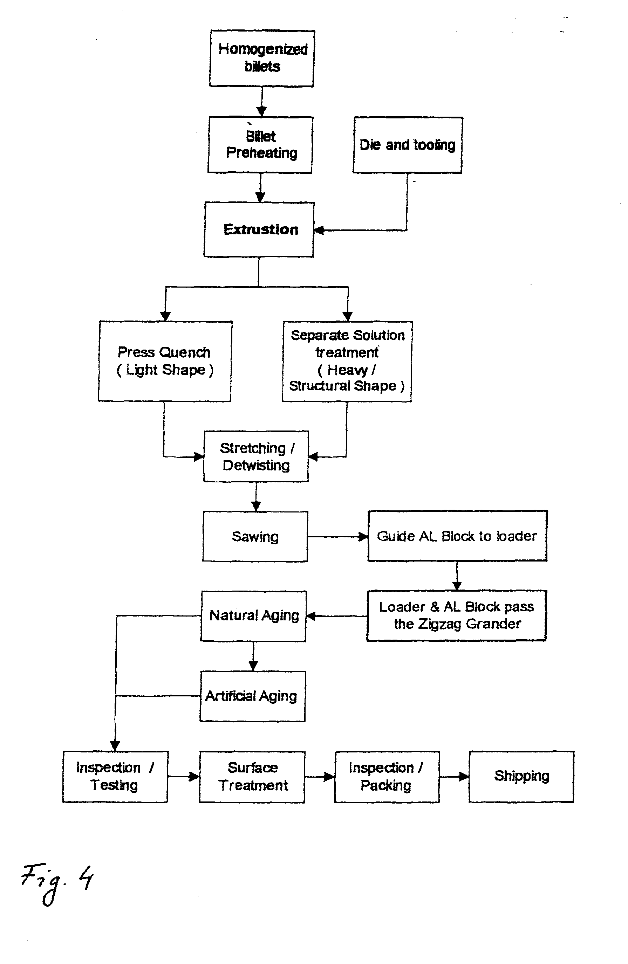

Fig. 3 shows a tunnel-type heat sink 16 according to the invention. Similar to the heat sink 9 shown in Fig. 2a the inventive heat sink 16 is provided with a plurality of fins 17. The predominant difference with regard to the conventional heat sink 9 shown in Fig. 2 is a triangular shape of the front end 18 of the fins 17 instead of a flat one. Like in the known tunnel-type heat sink 9 (Fig. 2a) the fins 17 are connected with a tunnel wall forming a base 19 of the heat sink 16. The triangular shape of the front ends of the fins allow maintaining a substantially laminar airflow through the tunnel or at least a reduction of the formation of turbulences. As a consequence the cooling performance of the heat sink 17 is improved and makes it possible to use a less powerful fan or a smaller heat sink under the same cooling requirements. This makes the inventive heat sink 16 more cost-efficient compared to the conventional tunnel-type heat sink 9 (Fig. 2a). In other words the inventive heat sink 16 is able to handle a larger power dissipation compared to traditional ones. In addition, these achievements are realised at reduced noise levels.

The shape of the cross section can be a triangular, a circular or a streamline curve or any curve that is suitable to maintain a substantially laminar flow of a forced airflow. The exact shape is not essential as long as the desired function is achieved.

Fig. 4 illustrates a flow diagram of a first method for manufacturing the heat sink. After conventional extrusion of a rod-like profiled body made from aluminium or an aluminium alloy, the profiled body is sawed into smaller parts. The front ends of the parts are then machined in a guiding machine to make the desired shape of the front ends of the fins.

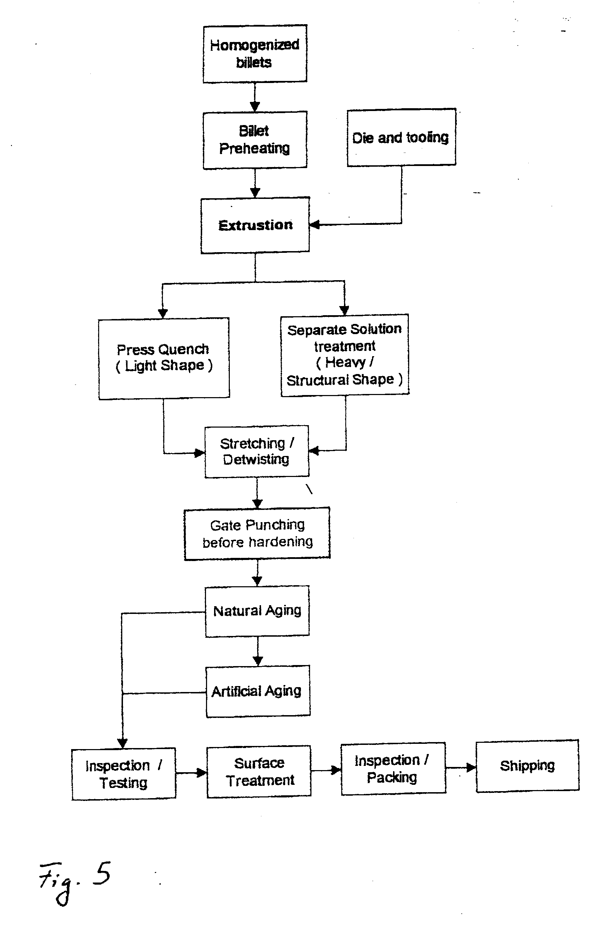

Fig. 5 displays a second method for manufacturing the inventive heat sink. According to this method the rod-like profiled body is punched into smaller parts. According to this method the desired shape of the cross section of the fins is achieved by the punching with an adapted tool.

## Claims

1. Heat sink comprising a base defining a base plane extending in a longitudinal and a transversal direction, the base being provided with at least one fin extending along the longitudinal direction and away from the base plane, wherein the base and the fin are arranged to allow an airflow along the longitudinal direction, **characterized in that** a front end (18) of the fin (17) facing the airflow exhibits a surface enabling a substantially laminar air flow.

2. Heat sink according to claim 1, **characterized in that** the front end (18) of the fin (17) has a triangular, circular or streamline cross-section.

3. Heat sink according to claim 1, **characterized in that** the base forms part of the tunnel guiding the airflow.

4. Heat sink according to claim 2, **characterized in that** the fins (17) extend to the interior of the tunnel.

5. Heat sink according to claim 2, **characterized in that** several sets of fins attached to different side walls of the tunnel are provided.

6. Method for manufacturing a heat sink by extruding a metal to produce a rod-like profiled body, **characterized by** separating the profiled body into several parts such that the cross-section of at least one front end of each part has a triangular shape.

7. Method according to claim 6, **characterized in that** the step of separating the profiled body is performed by punching the profiled body.

8. Method according to claim 6, **characterized in that** the step of separating the profiled body is performed by cutting the profiled body and subsequent grinding of at least one front end of each part of the profiled body.
